# EUROPÄISCHE PATENTANMELDUNG

(11) **EP 1 014 201 A2**
(43) Veröffentlichungstag der Anmeldung: **28.06.2000**
(21) Anmeldenummer: 99124380.9
(22) Anmeldetag: 07.12.1999
(51) Int. Cl.: G03F 9/00, G03F 7/20, G03F 7/095

(54) **Verfahren zur Herstellung von grossformatigen Verbund-Reliefdruckformen durch Laserpositionierung und anschliessende Bebilderung mittels Laser**

(30) Priorität: 23.12.1998 DE 19859631
(71) Anmelder: BASF Drucksysteme GmbH, 70469 Stuttgart (DE)
(72) Erfinder: Feil, Markus, 70499 Stuttgart (DE); Weidmann, Albrecht, 77694 Kehl (DE); Telser, Thomas, Dr., 69469 Weinheim (DE)

(57) **Zusammenfassung**

Verfahren zur Herstellung von großformatigen Verbund-Reliefdruckformen durch Aufbringen von einzelnen photopolymerisierbaren Reliefdruckformen auf einen großformatigen Träger, wobei die Übertragung der Bildinformation auf die einzelnen Reliefdruckformen mit einem Laser erfolgt. Verfahren, bei dem die Positionierung der einzelnen photopolymerisierbaren Reliefdruckfomen auf dem Träger mit Hilfe eines Lasers erfolgt. Verbund aus Reliefdruckformen aus einem Träger, einer darauf aufgebrachten laserstrukturierbaren, in Druckfarben und Druckplattenentwicklern unlöslichen Schicht, sowie darauf aufgebrachten Reliefdruckformen mit IR-ablatierbarer Schicht.

## Beschreibung

Die Erfindung betrifft ein Verfahren zur Herstellung von großformatigen Verbund-Reliefdruckformen durch Aufbringen von einzelnen photopolymerisierbaren Reliefdruckformen auf einen großformatigen Träger, wobei die Übertragung der Bildinformation auf die einzelnen Reliefdruckformen mit einem Laser erfolgt. Die Erfindung betrifft außerdem ein Verfahren, bei dem die Positionierung der einzelnen photopolymerisierbaren Reliefdruckformen auf dem Träger mit Hilfe eines Lasers erfolgt. Die Erfindung betrifft weiterhin einen Verbund aus Reliefdruckformen aus einem Träger, einer darauf aufgebrachten laserstrukturierbaren, in Druckfarben und Druckplattenentwicklern unlöslichen Schicht, sowie darauf aufgebrachten Reliefdruckformen mit IR-ablatierbarer Schicht.

Für das Bedrucken von sehr großen Flächen mit Reliefdruckplatten, wie zum Beispiel von Wellpappe für Kartonagen mit Flexodruckplatten, werden entsprechend große Druckplatten benötigt. Diese sind schwer zu handhaben und teuer. Häufig sollen auf einer großen Gesamtfläche nur eine oder mehrere kleine Teilflächen bedruckt werden. Hierfür ist folgende Vorgehensweise üblich: Die für die zu bedruckenden Teilflächen nötigen Druckklischees werden aus einzelnen, kleinen photopolymeren Druckplatten hergestellt und auf einer Montagefolie an der Stelle aufgeklebt, an der das Druckbild innerhalb der Gesamtfläche erscheinen soll. Die mit den einzelnen Klischees beklebte Montagefolie wird mittels einer an ihr befestigten Winkelleiste in den Druckzylinder eingehakt und auf ihm in definierter Position befestigt. Bei Mehrfarbendruck wird für jede Farbe eine solche Montagefolie mit entsprechenden Klischees erstellt.

Die Montage der Druckklischees ist jedoch zeitlich wie personell äußerst aufwendig. Bei Mehrfarbsätzen muss die Montage sehr positionsgenau erfolgen, damit die verschiedenen Farbpunkte im Druck präzise zueinander passen. Die punktgenaue Montage erfordert bislang Montagegeräte mit Videokameras zu Erfassung der Registermarken. Die passgenaue Montage muss aufwendig durch Übereinanderdrucken in einer Andruckvorrichtung getestet werden. Falls eine Farbe nicht passgenau druckt, muss die entsprechende Druckplatte von der Montagefolie entfernt und in verbesserter Position erneut aufgeklebt werden. Nach einer solchen Korrektur ist ein nochmaliger Andruck aller Farben zur erneuten Kontrolle erforderlich.

Es ist daher von WO 98/01792 vorgeschlagen worden, die Herstellung großflächiger Druckplatten mittels eines Ink-Jet-Verfahrens durchzuführen. Hierbei trägt ein Ink-Jet-Drucker Markierungen zur Positionierung der Einzelplatten auf einer Montagefolie auf. Nachdem photopolymere, also noch nicht belichtete und entwickelte Einzelplatten aufgeklebt worden sind, wird eine Photomaske mit einem Ink-Jet-Drucker auf die photopolymeren Einzelplatten aufgetragen. Anschließend wird der Plattenverbund als Ganzes belichtet und entwickelt. Die Bebilderung von photopolymeren Reliefdruckplatten mittels eines Ink-Jet-Verfahrens ist beispielsweise auch von EP-A 465 949, WO 97/25206 oder JP-A 63-109 052 offenbart worden.

Nachteilig an der Bebilderung mittels Ink-Jet-Verfahrens ist jedoch die geringe Auflösung, die beim Tintenstrahldrucker auf ungefähr 600 dpi begrenzt ist. Der Druckqualität sind somit Grenzen gesetzt.

Es ist bekannt, dass sich durch Bebilderung von Druckplatten mittels IR-Ablation, beispielsweise offenbart von EP-A 767 407 oder US 5,262,275, höhere Auflösungen erzielen lassen. Diese Vorteile ließen sich bislang jedoch bei der Herstellung großformatiger Druckplatten auf Montagefolie nicht nutzen, da sie durch die oben geschilderten Montageprobleme und mangelnde Passergenauigkeit wieder zunichte gemacht wurden.

Aufgabe der vorliegenden Erfindung war es daher, ein Verfahren zu finden, das die Herstellung von großformatigen Verbund-Reliefdruckformen durch direkte Bebilderung aus einem digitalen Datenbestand mit deutlich höherer Auflösung ermöglicht, als nach dem Stand der Technik bekannt.

Dementsprechend wurden das eingangs geschilderte Verfahren und die eingangs geschilderten Verbunde aus photopolymerisierbaren Reliefdruckformen gefunden.

Bei dem erfindungsgemäßen Verfahren wird zunächst ein dimensionsstabiler Träger mit Markierungen zum Positionieren der photopolymeren Druckplatten versehen. Unter dem Begriff dimensionsstabil ist zu verstehen, dass sich der Träger unter dem Einfluß von Umgebungsbedingungen, wie bspw. Temperaturschwankungen oder Schwankungen der Luftfeuchte nicht verziehen soll. Als dimensionsstabile Träger kommen insbesondere diejenigen Materialien zum Einsatz, die auch vorteilhaft als Träger für Flexo- oder Hochdruckplatten eingesetzt werden. Beispiele für derartige Materialien sind Folien aus Metallen wie Stahl, Aluminium, Kupfer oder Nickel oder aus Kunststoffen wie Polyethylenterephthalat (PET), Polybutylenterephthalat, Polyamid oder Polycarbonat. Als dimensionsstabile Träger kommen insbesondere Polyethylenterephthalat-Folien in Frage. Diese Trägerfolien sind im allgemeinen zwischen 100 und 500 µm, vorzugsweise 200 bis 500 µm und beispielsweise 250 µm dick.

Die Auswahl einer geeigneten Methode mit der der dimensionsstabile Träger mit Positionsmarkierungen versehen werden kann, ist nicht beschränkt. Prinzipiell kann jede Methode angewandt werden, die so gut sichtbare Markierungen auf dem Träger hinterlässt, so dass diese Markierungen ohne technische Hilfsmittel mit dem bloßen Auge erkennbar sind. Beispielsweise können die Positionsmarkierungen manuell, gegebenenfalls unterstützt durch geeignete Zeichen- oder Markierungswerkzeuge aufgebracht werden. Die Position der Markierungen wird dabei vorteilhaft mittels eines Computers mit Hilfe der Layout-Datenbestände errechnet. Weiterhin können Markierungen beispielsweise mit geeigneten Zeichengeräten oder Plottern aufgebracht werden.

In einer bevorzugten Ausführungsform werden die Positionsmarkierungen mit Hilfe eines IR-Lasers geschrieben. Diese Ausführungsform umfasst sowohl die Verwendung eines dimensionsstabilen Trägers, der selbst laserstrukturierbar ist. Ein derartiger Träger enthält Komponenten, die mit dem IR-Laser wechselwirken können. Die bevorzugte Ausführungsform der Erfindung umfasst weiterhin die Beschichtung eines dimensionsstabilen Trägers mit einer laserstrukturierbaren Schicht.

Die laserstrukturierbare Schicht auf dem Träger ist unlöslich und vorzugsweise auch nicht quellbar in den eingesetzten Druckfarben, wie beispielsweise Flexodruckfarben auf Basis von Wasser, Alkoholen und Estern, sowie in den üblicherweise zur Entwicklung der Reliefdruckplatten eingesetzten Entwicklern, wie beispielsweise solchen auf Basis von chlorierten Kohlenwasserstoffen oder hochsiedenden Kohlenwasserstofflösemitteln.

Die laserstrukturierbare Schicht auf dem Träger ist mittels eines IR-Lasers beschreibbar. Bei geeigneten laserstrukturierbaren Schichten handelt es sich beispielsweise um thermochrome Schichten, die bei Bestrahlung mit einem IR-Laser einen irreversiblen Farbumschlag aufweisen, oder es handelt sich um IR-ablative Schichten, die bei Bestrahlung mit einem IR-Laser abgetragen oder verdampft werden, wodurch der darunterliegende Träger wieder sichtbar wird.

Die thermochromen Schichten enthalten thermochrome Systeme. Im allgemeinen bestehen derartige thermochrome Systeme aus organischen Substanzen, die unter dem Einfluss von Aktivatoren, beispielsweise von Radikalen, Säuren, Basen oder Oxidationsmitteln, sich irreversibel in eine Form umlagern bzw. umwandeln, die ein anderes Absorptionsverhalten gegenüber Licht aufweist. Auf diese Art und Weise wird ein irreversibler Farbumschlag erreicht. Unter dem Einfluss von Wärme bewirken die Aktivatoren die Umwandlung der absorbierenden Substanzen. Geeignete thermochrome Systeme sind beispielsweise in der DE-A 33 42 579 offenbart. Ein Beispiel für ein derartiges System ist Michler's Keton mit Benzyltosylat als Aktivator.

Geeignete IR-ablative Schichten auf der Trägerfolie enthalten IR-absorbierende Materialien und weisen eine hohe Absorption im Wellenlängenbereich zwischen 750 und 20000 nm auf. Weiterhin weist die Schicht im sichtbaren Bereich des Spektrums, also im Wellenlängenbereich zwischen 400 und 750 nm, eine optische Dichte von mindestens 0,5, bevorzugt von mindestens 1,0 auf. Als IR-absorbierende Materialien kommen beispielsweise im IR absorbierende Farbstoffe wie Phthalocyanin-Verbindungen in Frage, außerdem stark gefärbte anorganische Pigmente wie Ruß, Graphit oder Chromoxide. Bevorzugt enthält die IR-ablative Schicht auf der Trägerfolie mindestens eine feinverteilte Substanz mit einer hohen Absorption im Wellenlängenbereich zwischen 750 und 20000 nm. Geeignete Substanzen sind insbesondere feinteilige Rußarten wie bspw. Printex® U (Fa. Degussa) mit einer mittleren Primärteilchengröße zwischen 13 und 30 nm.

Die laserstrukturierbare, in Druckfarben und Druckplattenentwicklern unlösliche Schicht auf der Trägerfolie ist vernetzt. Als vernetzende Bestandteile der Schicht können ein oder mehrere monomere oder oligomere Verbindungen eingesetzt werden. Die Vernetzung kann bei Raumtemperatur, bei erhöhten Temperaturen oder aber auch durch Bestrahlung mit aktinischem Licht erfolgen. Bei Strahlungshärtung werden zweckmäßigerweise geeignete Photoinitiatoren zugesetzt. Geeignete Bestandteile zur Vernetzung sind beispielsweise monomere oder oligomere multifunktionelle Isocyanate im Gemisch mit multifunktionellen Alkoholen wie bspw. Phenoxyharzen. Weiterhin geeignet sind beispielsweise ethylenisch ungesättigte Verbindungen, vorzugsweise mehrfach ethylenisch ungesättigte Verbindungen, die radikalisch polymerisierbar sind, in Kombinationen mit Photoinitiatoren. Besonders geeignet sind beispielsweise mono- und polyfunktionelle Acrylate und Methacrylate, wie bspw. Butylacrylat, 2-Ethylhexylacrylat, Hexandioldiacrylat, Hexandioldimethacrylat, Butandioldimethacrylat, Glycidyldimethacrylat oder Gemische davon.

Als zusätzliche Bindemittel kann die laserstrukturierbare Schicht bspw. Polycarbonate, Poly(meth)acrylate oder Poly(meth)acrylatester enthalten. Es können auch Gemische verschiedener Bindemittel eingesetzt werden. Sie kann darüber hinaus noch Bindemittel sowie zusätzliche Hilfsmittel wie bspw. Weichmacher, Dispergierhilfsmittel, Füllstoffe oder oberflächenaktive Substanzen enthalten. Die Schicht kann vorteilhaft durch Aufgießen aufgebracht werden, indem man die Bestandteile der Schicht in einem geeigneten Lösungsmittel löst, gegebenenfalls darin enthaltene Feststoffe, wie bspw. Ruß gleichmäßig durch Dispergieren darin verteilt, die Lösung gleichmäßig auf die Trägerfolie aufträgt und das Lösungsmittel abdampft. Falls erforderlich wird die aufgegossene Schicht anschliessend bei erhöhten Temperaturen oder durch Bestrahlen mit aktinischem Licht vernetzt. Alternativ kann die Schicht auch auf eine Folie gegossen, getrocknet und vernetzt werden, und diese Schicht anschliessend auf die Trägerfolie aufkaschiert werden, wobei man die Folie, auf die man die Schicht gegossen hat, wieder abzieht. Zweckmäßigerweise wird die Beschichtung auf eine gesamte Folienbahn aufgebracht, die als Vorrat zum Herstellen von großformatigen Verbund-Reliefdruckformen dient.

Bei Verwendung eines Trägers, der selbst laserstrukturierbar ist, kann die Beschichtung mit einer zusätzlichen laserstrukturierbaren Schicht entfallen. Laserstrukturierbare Träger enthalten Komponenten, die mit einem IR-Laser wechselwirken können, und durch die Wechselwirkung sichtbare Spuren auf dem Träger hinterlassen. Geeignete laserstrukturierbare Träger können beispielsweise erhalten werden, indem die oben geschilderten thermochromen Systeme bei der Herstellung einer Trägerfolie aus einem transparenten Polymeren direkt in diese eingearbeitet werden. Weiterhin können geeignete Träger erhalten werden, indem man IR-absorbierende Materialien mit einer hohe Absorption im Wellenlängenbereich zwischen 750 und 20000 nm in die Trägerfolie einarbeitet. Die IR-absorbierende Materialien enthaltende Folie sollte im sichtbaren Bereich des Spektrums, also im Wellenlängenbereich zwischen 400 und 750 nm, eine optische Dichte von mindestens 0,5, bevorzugt von mindestens 1,0 aufweisen. Durch die Bestrahlung mit einem IR-Laser wird oberflächlich Material der Polymerfolie ablatiert, so dass Strukturen auf der Trägerfolie erkennbar werden. Bei diesem Verfahren muss die Laserleistung sorgfältig eingestellt werden. Sie wird so gewählt, dass einerseits sichtbare Markierungen auf dem Träger erscheinen, andererseits aber eine Verringerung der Festigkeit oder gar ein vollständiges Durchtrennen der Folie vermieden wird.
Der laserstrukturierbare Träger bzw. der mit einer laserstrukturierbaren Schicht beschichtete Träger wird im nächsten Schritt mit Positionsmarkierungen für die einzelnen photopolymeren, eine IR-ablative Schicht umfassenden Drucktformen versehen, indem mit Hilfe von IR-Lasern Markierungen eingeschrieben werden. Geeignete IR-Laser zum Beschreiben der laserstrukturierbaren Schicht auf dem Träger sind beispielsweise Nd/YAG-Laser (1064 nm) oder Dioden-Laser (830 nm). Es können dabei sowohl solche Laserapparaturen eingesetzt werden, bei dem der Träger flach liegend eingebaut wird, als auch solche, bei dem der Träger auf einen rotierenden Zylinder montiert wird. Wenngleich nicht unbedingt erforderlich, werden für das erfindungsgemäße Verfahren vorteilhaft die gleichen Laserapparaturen eingesetzt, wie für das spätere Einschreiben der Bildmasken. Ein geeignetes Lasersystem ist bspw. das Diodenlaser-System OmniSetter® (Fa. Misomex, Laserwellenlänge 830 nm, Arbeitsbreite 1800 mm). Von wesentlicher Bedeutung für die Qualität des späteren Druckes ist es, dass die Trägerfolie positionsgenau in der Laserapparatur fixiert wird. Beispielsweise werden bei der Montage auf einen Zylinder die Trägerfolien mit Winkelleisten oder Passerstiften positionsgenau auf dem Zylinder ausgerichtet und mit Vakuum oder doppelseitigem Klebeband zur Laserbelichtung fixiert. Diese positionsgenauen Fixierungen in der Laserapparatur sind die Basis für die positionsgenauen Fixierungen auf dem Druckzylinder.

Als Positionsmarken können beispielsweise die Umrisse der auf zubringenden photopolymeren Reliefdruckformen eingeschrieben werden. Es können aber auch Winkel oder Kreuze eingeschrieben werden, die die Ecken der Druckformen markieren. Möglich ist jede Markierung, die es erlaubt, die Druckformen eindeutig und präzise zu positionieren. Anzahl, Größe und Position der einzelnen auf den Träger auf zubringenden photopolymeren Druckformen werden vorteilhaft mit Layout-Datenbeständen berechnet, und die Information zum Schreiben der Positionsmarken wird direkt aus dem Computer zum Lasersystem übertragen.

Im nächsten Schritt werden mit Hilfe der Positionsmarken photopolymere Reliefdruckfomen auf den Träger aufgebracht. Das Aufbringen kann nach dem Fachmann auf dem Gebiet bekannten Methoden erfolgen, beispielsweise durch Aufkleben mit Hilfe eines doppelseitigen Klebebandes. Die einzelnen Druckformen werden falls erforderlich vor dem Aufbringen auf die erforderliche Größe zurechtgeschnitten. Für das erfindungsgemäße Verfahren ist es ausreichend, wenn die Platte nur max. ½ cm Rand aufweist, der nicht bebildert werden soll. Die Anzahl der einzelnen Druckformen richtet sich nach dem gewünschten Druckbild. Zum Aufbringen der photopolymerisierbaren Druckformen verbleibt der Träger vorteilhaft in der Laserapparatur fixiert, also beispielsweise auf dem Zylinder. Diese Vorgehensweise vermeidet ein erneutes Positionieren zum Einschreiben der Bildmaske.

Bei den photopolymerisierbaren Reliefdruckformen handelt es sich um übliche photopolymerisierbare Flexodruck- oder Hochdruckformen, die mit einer IR-ablativen Schicht versehen sind. Derartige Druckformen sind dem Fachmann prinzipiell bekannt. Sie umfassen üblicherweise eine dimensionsstabile Trägerfolie, mindestens eine photopolymerisierbare Schicht sowie eine darauf befindliche IR-ablative Schicht. Die IR-ablative Schicht besitzt eine optische Dichte im aktinischen Bereich von mindestens 2,5 und besitzt außerdem eine hohe Absorption im infraroten Bereich des Spektrums. Vorteilhaft enthält sie mindestens eine feinverteilte Substanz mit einer hohen Absorption zwischen 750 und 20000 nm. Sie kann weiterhin ein Bindemittel enthalten. Vorteilhaft handelt es sich dabei um ein filmbildendes Bindemittel mit elastomerem Charakter wie beipielsweise ein Polyamid-Harz (z.B. Makromelt® der Fa. Henkel) oder ein Polyvinylalkohol/Polyethylenglykol-Propfcopolymeres (z.B. Mowiol® GE 597 der Fa. Hoechst). Auf der IR-ablativen Schicht kann sich zusätzlich eine Schutzfolie befinden. Sie kann außerdem noch weitere Schichten wie beipielsweise Haft- oder Entklebungsschichten umfassen. Die photopolymerisierbare Schicht umfasst üblicherweise Bindemittel, ethylenisch ungesättigte Verbindungen, Photoinitiatoren sowie gegebenenfalls weitere Additive und Hilfsmittel wie beispielsweise Weichmacher, Farbstoffe, Antioxidantien oder Inhibitoren für die thermische Polymerisation. Geeignete photopolymerisierbare Reliefdruckformen mit IR-ablativer Schicht sind beispielsweise in EP-A 767 407 oder US 5, 262, 275 offenbart und unter der Bezeichnung Cyrel® DPS (Fa. Du Pont) oder digiflex® (Fa. BASF) im Handel erhältlich.

Falls erforderlich wird mit den einzelnen photopolymerisierbaren Druckformen vor dem Aufbringen in bekannter Weise eine Rückseitenbelichtung durchgeführt.

Nach dem Aufbringen der photopolymerisierbaren Druckformen auf die beschichtete Trägerfolie wird mit Hilfe eines IR-Lasers oder -Lasersystems eine Bildmaske in die IR-ablative Schicht der einzelnen Druckformen des Plattenverbundes geschrieben. Geeignete IR-Laser zum Ablatieren sind beispielsweise Nd/YAG-Laser (1064 nm) oder Dioden-Laser (830 nm). Geeignete Lasersysteme zum Ablatieren sind kommerziell im Handel erhältlich, bspw. das Diodenlaser-System OmniSetter® (Fa. Misomex, Laserwellenlänge 830 nm, Arbeitsbreite 1800 mm). Die Bildinformation wird direkt aus dem Computer zum Lasersystem übertragen.

Nach dem Einschreiben der Bildmaske in die IR-ablative Schicht erfolgt die vollflächige Belichtung des Plattenverbundes mit aktinischem Licht. Dies kann entweder direkt auf dem Laserzylinder erfolgen, oder man demontiert die Platte und belichtet in einem konventionellen Flachbelichter (z.B. F IV-Belichter der Fa. BASF). Anschließend wird der gesamte belichtete Plattenverbund zu einer Druckform entwickelt. Dazu kann man handelsübliche Durchlauf- oder Rundwascher benutzen. Je nach der Chemie der Platte werden wässrige oder organische Lösungsmittelgemische zum Entwicklen des Plattenverbundes gewählt. Geeignete wässrige Lösungsmittelgemische sind beispielsweise Wasser/Alkohol-Gemische. Geeignete organische Lösungsmittelgemische sind beispielsweise Perchlorethylen/Butanol-Gemische oder Nylosolv® (Kohlenwasserstoff/Alkohol-Gemisch). Im Zuge der Entwicklung werden die nicht vernetzten Bestandteile der photopolymerisierbaren Schicht herausgewaschen. Es ist auch möglich, die Reste der IR-ablativen Schicht zunächst mit einem Vorentwickler zu entfernen, und dann erst die Platte zu entwicklen. Die vernetzte, laserstrukturierbare Schicht auf dem Träger bleibt im Zuge der Entwicklung erhalten und löst sich nicht vom Träger. Nach dem Entwickeln wird der gesamte Plattenverbund getrocknet. Er kann anschliessend üblichen Nachbehandlungsmethoden unterworfen werden, z.B. einer Nachbehandlung mit UV-C-Licht oder einer Entklebebehandlung mit Br₂.

Mit dem erfindungsgemäßen Verfahren wird für jede Druckfarbe eine Verbund-Reliefdruckform hergestellt. Sie können ohne Zeitverlust direkt auf ein Mehrfarbdruckwerk passergenau montiert werden, ohne dass die aufgeklebten Einzeldruckplatten noch nachjustiert werden müssen und mit einer hervorragenden Passergenauigkeit verdruckt werden. Die durch das Lasersystem prinzipiell ermöglichte Auflösung von bis zu 2540 dpi kann somit auch für den Mehrfarbrasterflexodruck tatsächlich genutzt werden.

Das folgende Beispiel soll die Erfindung näher erläutern, ohne dass dadurch der Umfang der Erfindung eingeschränkt wird.

### Beispiel

Als Montagefolie wurde eine mit Trichloressigsäure (TCE) vorbehandelte Polyethylenterephtalat-Folie (Hostaphan® RNH250, Hoechst-Diafoil GmbH) mit einer Dicke von 250 µm verwendet. Die beschriebene Folie ist transparent und läßt sich weder mit einem Nd/YAG-Laser (1064 nm) noch mit einem Dioden-Laser (830 nm) kennzeichnen.

Auf die TCE behandelte Seite der Folie wurde eine laserstrukturierbare und gleichzeitig haftvermittelnde Schicht aufgebracht. Rezeptur der haftvermittelnden und laserstrukturierbren Schicht:
- 32,0 g: Phenoxyharz (Polyhydroxyether von Union Carbide)
- 20,0 g: Ruß (PrintexU® von Degussa)
- 38,8 g: Isocyanat (Desmodur® L67 von Bayer AG)

Das Phenoyharz wurde in Tetrahydrofuran/Dioxan (1:1) gelöst. Zu der kalten Lösung wurde der Ruß und das Isocyanat zugegeben und diese Mischung 30 Minuten mit Hilfe eines Ultra-Turrax dispergiert. Mit Tetrahydrofuran/Dioxan (1:1) wurde die Mischung auf 7,7% Feststoff verdünnt und mittels eines Rakels auf die PET-Folie aufgezogen. Es wurde ein Gießspalt von 100 µm eingestellt, das Naßgewicht der Beschichtung betrug 65 g/m². Die so beschichtete Folie wurde 7 Minuten bei 85°C im Umlufttrockenschrank getrocknet. Nach der Lackierung hatte die Folie eine optische Dichte von 1,5. Diese Schwärzung war ausreichend, um mit einem Diodenlaser oder einem Neodym-YAG Laser deutlich sichtbare Linien variabler Breite einzuschreiben.

Die Montagefolie (Größe 1200 x 1600 mm) wurde an der längeren Seite mit einer im Wellpappendruck üblichen Führungsschiene verbunden und justiert. Die Montagefolie wurde auf dem Zylinder eines Diodenlasersystems der Fa. Misomex (OmniSetter® 7000, Laserwellenlänge 830 nm, Arbeitsbreite 1800 mm) aufgebracht, wobei der Zylinder für die Aufnahme der Führungsschiene modifiziert (ausgespart) worden war. Die Montagefolie wurde mit Vakuum auf dem Zylinder fixiert. Zur Sicherheit wurden die Ränder der Montagefolie mit Klebeband abgeklebt.

Danach wurden mittels der Laserdioden Markierungskreuze dort auf der Montagefolie erzeugt, wo später die zugeschnittenen Druckplatten plaziert werden sollen. Auf die markierten Flächen wurde ein doppelseitig klebendes Band aufgebracht. Hierzu ist Klebeband auf einer zur Zylinderachse koaxial angeordneten Achse vorhanden. Die Achse ist so angebracht, daß sie bei Bedarf in Position gebracht werden kann und beim Lasern weggeschwenkt werden kann. Die Position der Klebebandrolle auf der Achse kann lateral verschoben werden. Die Klebeschichten wurden nun durch Abrollen möglichst blasenfrei auf die gekennzeichneten Flächen übertragen.

Anschließend wurden auf die Klebeschichten zuvor passgenau zugeschnittene Plattenstücke photopolymerer Flexodruckplatten (digiflex® FA II D 284, BASF) aufgebracht. Vor dem Aufbringen wurden die Plattenstücke 20 s von der Rückseite vorbelichtet. Ca. 30% der Montagefolienfläche war mit photopolymeren Druckformen bedeckt.

Die digiflex® FA II D 284 Druckplatten sind wie folgt aufgebaut: Auf einer 125 µm starken PET-Trägerfolie befindet sich ein ca. 5 µm dünner Haftlack. Darauf befindet sich die lichtempfindliche Schicht. Darauf ist die IR-Laser sensitive Schicht aufgebracht. Sie ist 2,5 µm dick und besteht zu ca. 70 Gew. % aus einem elastomeren Polyamid (Makromelt 6900 von Henkel) und zu ca. 30 Gew. % aus Ruß (Printex® U von Degussa). Die optische Dichte der schwarzen Schicht liegt bei 3,2. Den Abschluß bildet eine 125 µm starke PET-Deckfolie.

Nach dem Aufbringen der Plattenstücke wurden die Deckfolien entfernt und mittels des Misomex-Diodenlasers die Information auf die Druckplatten eingeschrieben (Spotgröße 12,5 µm, Laserleistung 20 W verteilt auf 20 Laserdioden, Trommelrotation 100 U/min, Auflösung 2032 dpi). Zum Einschreiben der Bildmasken wurden 20 min benötigt.

Nach der Bebilderung wurde die gesamte Druckform (belichtete Druckplatten auf Montagefolie) demontiert und konventionell (d.h. flach) weiterverarbeitet. Folgende Schritte wurden durchgeführt:
1. UV-Belichtung, F-III Belichter BASF, 15 Minuten
2. Auswaschen des Reliefs, Auswaschmittel nylosolv II BASF 30°C, F-IV Durchlaufwascher BASF
3. Trocken bei 60°C
4. Nachbelichtung und Nachbehandlung (UV C-Licht), jeweils 10 Minuten

Für jeden Farbauszug wurde nach diesem Verfahren eine Druckform hergestellt. Die Druckformen wurden auf die Zylinder einer Wellpappendruckmaschine aufgespannt und mit wasserbasierenden Flexodruckfarben verdruckt. Es wurde ein Rasterflexodruck mit ausgezeichneter Passergenauigkeit und hervorragender Auflösung erhalten.

Das Beispiel zeigt sehr deutlich die besonderen Vorteile des erfindungsgemäßen Verfahrens: Zum einen wird eine hervorragende Passergenauigkeit erzielt. Die hervorragende Auflösung digital mit Lasern bebilderter Flexodruckplatten wird auch mit den Verbund-Reliefdruckformen erreicht. Im Vergleich zur Verwendung einer einzigen großen photopolymeren Druckplatte mit IR-ablativer Schicht wird zum einen Druckplattenmaterial eingespart und zum anderen kann die teure Laserzeit auf das unbedingt notwendige Maß beschränkt werden.

## Patentansprüche

1. Verfahren zur Herstellung von großformatigen Verbund-Reliefdruckformen, umfassend die folgenden Schritte:
(a) Versehen eines dimenssionsstabilen Trägers mit Positionsmarkierungen,
(b) Positionieren und Befestigen von mindestens einer photopolymerisierbaren Reliefdruckform mit IR-ablatierbarer Schicht auf dem dimensionsstabilen Träger mit Hilfe der Positionsmarkierungen,
(c) Einschreiben einer Bildmaske in die IR-ablatierbare Schicht der photopolymerisierbaren Reliefdruckformen mit Hilfe eines Lasers,
(d) vollflächiges Belichten des gesamten Verbundes mit aktinischem Licht,
(e) Auswaschen der unbelichteten Anteile der photopolymerisierbaren Druckformen mit einem Entwickler.

2. Verfahren zur Herstellung von großformatigen Verbund-Relief-druckformen gemäß Anspruch 1, dadurch gekennzeichnet, dass es sich bei der photopolymerisierbaren Reliefdruckform mit IR-ablatierbarer Schicht um ein mehrschichtiges Aufzeichnungselement handelt, das mindestens eine dimensionsstabile Trägerfolie, eine photopolymerisierbare Schicht sowie eine darauf befindliche IR-ablatierbare Schicht umfasst.

3. Verfahren zur Herstellung von großformatigen Verbund-Relief-druckformen gemäß Anspruch 2, dadurch gekennzeichnet, dass die IR-ablatierbare Schicht in einem filmbildenden Bindemittel mindestens eine Substanz feinverteilt enthält, die eine hohe Absorption im Wellenlängenbereich zwischen 750 und 20000 nm und eine optische Dichte im aktinischen Bereich von mindestens 2,5 aufweist.

4. Verfahren zur Herstellung von großformatigen Verbund-Reliefdruckformen gemäß Anspruch 3, dadurch gekennzeichnet, dass die photopolymerisierbare Druckform als oberste Schicht zusätzlich eine Schutzfolie umfasst, die vor dem Einschreiben der Bildmaske abgezogen wird.

5. Verfahren zur Herstellung von großformatigen Verbund-Reliefdruckformen gemäß einem der Ansprüche 1 bis 4, dadurch gekennzeichnet, dass man den dimensionsstabilen Träger mit einer laserstrukturierbaren, in Druckfarben und Druckplattenentwicklern unlöslichen Schicht beschichtet und unter Verwendung eines IR-Lasers Positionsmarkierungen in die laserstrukturierbare Schicht schreibt.

6. Verfahren zur Herstellung von großformatigen Verbund-Reliefdruckformen gemäß Anspruch 5, dadurch gekennzeichnet, dass die laserstrukturierbare Schicht auf dem dimensionsstabilen Träger mindestens eine Substanz feinverteilt enthält, die eine hohe Absorption im Wellenlängenbereich zwischen 750 und 20000 nm aufweist und die laserstrukturierbare Schicht im sichtbaren Bereich des Spektrums eine optische Dichte von mindestens 0,5 aufweist.

7. Verfahren zur Herstellung von großformatigen Verbund-Reliefdruckformen gemäß Anspruch 5, dadurch gekennzeichnet, dass das die laserstrukturierbare Schicht ein themochromes System enthält.

8. Verfahren zur Herstellung von großformatigen Verbund-Reliefdruckformen gemäß einem der Ansprüche 1 bis 4, dadurch gekennzeichnet, dass man einen dimensionsstabilen Träger einsetzt, der selbst laserstrukturierbar ist, und unter Verwendung eines IR-Lasers Positionsmarkierungen in den Träger schreibt.

9. Verfahren zur Herstellung von großformatigen Verbund-Reliefdruckformen gemäß einem der Ansprüche 1 bis 4, dadurch gekennzeichnet, dass man Positionsmarkierungen manuell auf den dimensionsstabilen Träger aufbringt.

10. Verbund aus photopolymerisierbaren Reliefdruckformen umfassend
• einen dimensionsstabilen Träger,
• eine unmittelbar darauf aufgebrachte laserstrukturierbare, in Druckfarben und Druckplattenentwicklern unlösliche Schicht, sowie
• eine oder mehrere darauf aufgebrachte photopolymerisierbare Reliefdruckformen mit IR-ablatierbarer Schicht.

11. Verbund aus photopolymerisierbaren Reliefdruckfomen gemäß Anspruch 10, dadurch gekennzeichnet, dass die photopolymerisierbaren Reliefdruckformen mindestens eine dimensionsstabile Trägerfolie, eine photopolymerisierbare Schicht sowie eine darauf befindliche IR-ablatierbare Schicht umfassen.

12. Verbund aus photopolymerisierbaren Reliefdruckfomen gemäß Anspruch 11, dadurch gekennzeichnet, dass die IR-ablatierbare Schicht in einem filmbildenden Bindemittel mindestens eine Substanz feinverteilt enthält, die eine hohe Absorption im Wellenlängenbereich zwischen 750 und 20000 nm und eine optische Dichte im aktinischen Bereich von mindestens 2,5 aufweist.

13. Verbund aus photopolymerisierbaren Reliefdruckfomen gemäß Anspruch 12, dadurch gekennzeichnet, dass die photopolymerisierbaren Reliefdruckformen als oberste Schicht zusätzlich eine Schutzfolie umfassen.

14. Verbund aus photopolymerisierbaren Reliefdruckfomen gemäß einem der Ansprüche 10 bis 13, dadurch gekennzeichnet, dass die laserstrukturierbare Schicht auf dem dimensionsstabilen Träger mindestens eine Substanz feinverteilt enthält, die eine hohe Absorption im Wellenlängenbereich zwischen 750 und 20000 nm aufweist, und die laserstrukturierbare Schicht im sichtbaren Bereich des Spektrums eine optische Dichte von mindestens 0,5 aufweist.
